(19)

Europäisches
Patentamt
European
Patent Office
Office européen
des brevets

(11) **EP 3 301 810 B1**

(12) **EUROPEAN PATENT SPECIFICATION**

(45) Date of publication and mention
of the grant of the patent:
**13.02.2019 Bulletin 2019/07**

(51) Int Cl.:
***H03H 21/00*** *(2006.01)*

(21) Application number: **16191469.2**

(22) Date of filing: **29.09.2016**

(54) **ADAPTIVE FILTER CIRCUITS AND METHODS**

ADAPTIVE FILTERSCHALTUNGEN UND VERFAHREN

CIRCUITS ET PROCÉDÉS DE FILTRE ADAPTATIF

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.04.2018 Bulletin 2018/14**

(73) Proprietor: **Intel IP Corporation
Santa Clara, CA 95054 (US)**

(72) Inventors:
• **NOEST, Peter
81735 München (DE)**
• **WOLFERT, Robert Bob
Scottsdale, AZ Arizona 85260 (US)**

• **JOSHI, Gaurav
Tempe, AZ Arizona 85283 (US)**
• **RAHMAN, Mahibur Mahib
Chandler, AZ Arizona 85248 (US)**
• **HAHN, Markus Max
A-4252 Liebenau, 4 (AT)**

(74) Representative: **Viering, Jentschura & Partner
mbB
Patent- und Rechtsanwälte
Am Brauhaus 8
01099 Dresden (DE)**

(56) References cited:
**EP-A2- 0 400 850**   **US-A1- 2004 047 464**
**US-A1- 2013 173 678**   **US-A1- 2014 247 757**
**US-B1- 9 407 298**

EP 3 301 810 B1

## Description

### Technical Field

Various aspects of this disclosure relate generally to a method and a device for adaptive filtering.

### Background

Adaptive filters are computational devices that attempt to model the relationship between two signals in real time in an iterative manner by modifying variable parameters in each iteration. The least mean square (LMS) algorithm is one of the most used methods for adjusting the variable parameters of an adaptive filter. LMS adaptive filters provide for high levels of accuracy when using small step sizes, but these adaptive filters deliver slow convergence. On the other hand, large step sizes lead to instability. An alternative to the LMS algorithm for adaptive filtering is the normalized LMS (NMLS) algorithm, which normalizes the LMS with the power of the input to the adaptive filter. While improving the convergence and providing stability, the NLMS based filters lack on accuracy. Another method used in adaptive filtering is the recursive least square (RLS) algorithm, which provides both fast convergence and high accuracy. However, these benefits come at the cost of high computational complexity.

The extended LMS (XLMS) algorithm and mechanisms disclosure herein provide for both fast convergence and high accuracy at low computational complexity, thereby minimizing hardware requirements.

US 20130173678 describes a multi-stage adaptive filter which manipulates the weighting parameters in multiple stages in order to minimize the error of the filtered signal.

US 20040047464 describes an adaptive noise canceling microphone system with an adaptive noise cancellation filtering circuit being adapted to receive a speech enhanced signal and a speech nulled signal wherein the noise in the speech enhanced signal is cancelled using the speech null signal as a reference.

EP 0 400 850 describes a system and method for generating digital filter coefficients utilizing an iterative adaptive process employing a least mean square process wherein the filter coefficients are updated by an amount during each iteration dependent upon a stochastic average of the gradients generated during prior iterations.

US 9407298 describes method for interference cancellation including determining coefficients for one or more adaptive filters configured as least mean square (LMS) adaptive filters.

US 20140247757 describes devices with single or multi-tap analog adaptive filter configured to generate an estimated transmit leakage signal based on at least a portion of a transmit signal from the transmitter and an error signal from the receiver, wherein the adaptive filters are configured as LMS adaptive filters.

### Brief Description of the Drawings

In the drawings, like reference characters generally refer to the same parts throughout the different views. The drawings are not necessarily to scale, emphasis instead generally being placed upon illustrating the principles of the invention. In the following description, various embodiments of the invention are described with reference to the following drawings, in which:

FIG. **1** shows a basic adaptive filter arrangement in an aspect of this disclosure;
FIG. **2** shows a detailed adaptive filter arrangement in an aspect of this disclosure;
FIG. **3** shows a hardware implementation for an adaptive filter circuit in an aspect of this disclosure;
FIG. **4** shows a step size table for an adaptive filter algorithm in an aspect of this disclosure;
FIG. **5** shows a comparison of the results of the methods and devices in this disclosure with known methods;
FIG. **6** is a graph showing a settling performance of the methods and devices of this disclosure;
FIG. **7** is a graph showing a settling performance of the methods and devices of this disclosure;
FIG. **8** shows a configuration of a device which implements the circuitry and methods in an aspect of this disclosure;
FIG. **9** shows a flowchart for an adaptive filter method in an aspect of this disclosure.

### Description

The following details description refers to the accompanying drawings that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

The words "plural" and "multiple" in the description and the claims, if any, are used to expressly refer to a quantity greater than one. Accordingly, any phrases explicitly invoking the aforementioned words (e.g. "a plurality of [objects]", "multiple [objects]") referring to a quantity of objects is intended to expressly refer more than one of the said objects. The terms "group", "set", "collection", "series", "sequence", "grouping", "selection", etc., and the like in the description and in the claims, if any, are used to refer to a quantity equal to or greater than one, i.e. one or more. Accordingly, the phrases "a group of [objects]", "a set of [objects]", "a collection of [objects]", "a series of [objects]", "a sequence of [objects]", "a grouping of [objects]", "a selection of [objects]", "[object] group", "[object] set", "[object] collection", "[object] series", "[object] sequence", "[object] grouping", "[object] selection", etc., used herein in relation to a quantity of objects is intended to refer to a quantity of one or more of said objects. It is appreciated that unless directly referred to with an explicitly stated plural quantity (e.g. "two [objects]" "three of the [objects]", "ten or more [objects]", "at least four [objects]", etc.) or express use of the words "plural", "multiple", or similar phrases, references to quantities of objects are intended to refer to one or more of said objects.

A "circuit" as used herein is understood as any kind of logic-implementing entity, which may include special-purpose hardware or a processor executing software. A circuit may thus be an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions which will be described below in further detail may also be understood as a "circuit". It is understood that any two (or more) of the circuits detailed herein may be realized as a single circuit with substantially equivalent functionality, and conversely that any single circuit detailed herein may be realized as two (or more) separate circuits with substantially equivalent functionality. Additionally, references to a "circuit" may refer to two or more circuits that collectively form a single circuit. The term "circuit arrangement" may refer to a single circuit, a collection of circuits, and/or an electronic device composed of one or more circuits.

A "processing circuit" (or equivalently "processing circuitry" or "processer") as used herein is understood as referring to any circuit that performs an operation(s) on signal(s), such as e.g. any circuit that performs processing on an electrical signal or an optical signal. A processing circuit may thus refer to any analog or digital circuitry that alters a characteristic or property of an electrical or optical signal, which may include analog and/or digital data. A processing circuit may thus refer to an analog circuit (explicitly referred to as "analog processing circuit(ry)"), digital circuit (explicitly referred to as "digital processing circuit(ry)"), logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Accordingly, a processing circuit may refer to a circuit that performs processing on an electrical or optical signal as hardware or as software, such as software executed on hardware (e.g. a processor or microprocessor). As utilized herein, "digital processing circuit(ry)" may refer to a circuit implemented using digital logic that performs processing on a signal, e.g. an electrical or optical signal, which may include logic circuit(s), processor(s), scalar processor(s), vector processor(s), microprocessor(s), controller(s), microcontroller(s), Central Processing Unit(s) (CPU), Graphics Processing Unit(s) (GPU), Digital Signal Processor(s) (DSP), Field Programmable Gate Array(s) (FPGA), integrated circuit(s), Application Specific Integrated Circuit(s) (ASIC), or any combination thereof. Furthermore, it is understood that a single a processing circuit may be equivalently split into two separate processing circuits, and conversely that two separate processing circuits may be combined into a single equivalent processing circuit.

As used herein, "memory" may be understood as an electrical component in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, etc., or any combination thereof. Furthermore, it is appreciated that registers, shift registers, processor registers, data buffers, etc., are also embraced herein by the "term" memory. It is appreciated that a single component referred to as "memory" or "a memory" may be composed of more than one different type of memory, and thus may refer to a collective component comprising one or more types of memory. It is readily understood that any single memory "component" may be distributed or/separated multiple substantially equivalent memory components, and vice versa. Furthermore, it is appreciated that while "memory" may be depicted, such as in the drawings, as separate from one or more other components, it is understood that memory may be integrated within another component, such as on a common integrated chip.

For purposes of this disclosure, radio communication technologies may be classified as one of a Short Range radio communication technology, Metropolitan Area System radio communication technology, or Cellular Wide Area radio communication technology. Short Range radio communication technologies include Bluetooth, WLAN (e.g. according to any IEEE 802.11 standard), and other similar radio communication technologies. Metropolitan Area System radio communication technologies include Worldwide Interoperability for Microwave Access (WiMax) (e.g. according to an IEEE 802.16 radio communication standard, e.g. WiMax fixed or WiMax mobile) and other similar radio communication technologies. Cellular Wide Area radio communication technologies include Global System for Mobile Communications (GSM), Code Division Multiple Access 2000 (CDMA2000), Universal Mobile Telecommunications System (UMTS), Long Term Evolution (LTE), General Packet Radio Service (GPRS), Evolution-Data Optimized (EV-DO), Enhanced Data Rates for GSM Evolution (EDGE), High Speed Packet Access (HSPA), etc., and other similar radio communication technologies. Cellular Wide Area radio communication technologies also include "small cells" of such technologies, such as microcells, femtocells, and picocells. Cellular Wide Area radio communication technologies may be generally referred to herein as "cellular" communication technologies. It is understood that exemplary scenarios detailed herein are demonstrative in nature, and accordingly may be similarly applied to various other mobile communication technologies, both existing and not yet formulated, particularly in cases where such mobile communication technologies share similar features as disclosed regarding the following examples.

The term "network" as utilized herein, e.g. in reference to a communication network such as a mobile communication network, is intended to encompass both an access component of a network (e.g. a radio access network (RAN) component) and a core component of a network (e.g. a core network component).

Unless explicitly specified, the term "transmit" encompasses both direct (point-to-point) and indirect transmission (via one or more intermediary points). Similarly, the term "receive" encompasses both direct and indirect reception. The term "communicate" encompasses one or both of transmitting and receiving, i.e. unidirectional or bidirectional communication in one or both of the incoming and outgoing directions. The term "calculate" encompass both 'direct' calculations via a mathematical expression/formula/relationship and 'indirect' calculations via lookup tables and other array indexing or searching operations.

It is appreciated that any vector and/or matrix notation utilized herein is exemplary in nature and is employed solely for purposes of explanation. Accordingly, it is understood that the approaches detailed in this disclosure are not limited to being implemented solely using vectors and/or matrices, and that the associated processes and computations may be equivalently performed with respect to sets, sequences, groups, etc., of data, observations, information, signals, samples, symbols, elements, etc. Furthermore, it is appreciated that references to a "vector" may refer to a vector of any size or orientation, e.g. including a 1x1 vector (e.g. a scalar), a 1xM vector (e.g. a row vector), and an Mx1 vector (e.g. a column vector). Similarly, it is appreciated that references to a "matrix" may refer to matrix of any size or orientation, e.g. including a 1x1 matrix (e.g. a scalar), a 1xM matrix (e.g. a row vector), and an Mx1 matrix (e.g. a column vector).

The subject matter disclosed herein provides devices and methods for adaptive filtering with fast convergence and high accuracy at low computation complexity. The disclosure herein improves the LMS adaptive filtering algorithm settling time and accuracy close to the performance of the very hardware intensive RLS algorithm, and, in some cases, even improves upon the RLS performance. The adaptive filtering methods and devices herein may be used in many implementations, including, but not limited to: self-interference cancellation (SIC), modulated spur cancellation, nth harmonic cancellation, IM3 cancellation, digital pre-distortion, and 3G Radio Resource Control (RRC) equalization. For example, the mechanisms and methods herein disclosed may be implemented into a baseband modem of a wireless device for transmission (TX)-reception (RX) crosstalk, repeater, or audio applications. In another example, the disclosed mechanisms and methods may be applied to adaptive equalizers for cellular and connectivity for time domain equalization, e.g. CDMA baseband modems.

For LMS, the step size of each iteration ($\mu$) must be chosen to be relatively small to avoid stability problems as well as achieving accuracy. However, this small step size increases the settling time (i.e. convergence), and thereby decreasing the stability. NLMS solves the stability issue, but does so at the sacrifice of accuracy, especially in the presence of an interferer or noise. The solution presented by RLS is hardware intensive (i.e. needs more hardware due to high computation complexity) and has a lower tracking capability in a settled condition. Tracking is an adaptive filters ability to alter its parameter values to follow the changes in its input with that of a received signal.

The disclosure herein provides two elements from which to select the lower step size in each iteration of the cancellation signal (i.e. adaptive filter output): a step size which decreases with time and a step size dependent on the power of the input signal to the adaptive filter. The step size dependent on power is similar to step size determination in the NLMS method. In another aspect of this disclosure, the step size dependent on time may be scaled to account for interference and noise in order to deliver even better results.

In the adaptive filtering mechanisms and methods presented in this disclosure, the initial step sizes of the adaptive filter are dominated by the power dependent step size (i.e. similar to NLMS) which provides for fast convergence while maintaining stability, but in the later stages, the step size selection is dominated by the time dependent step size, ensuring high accuracy.

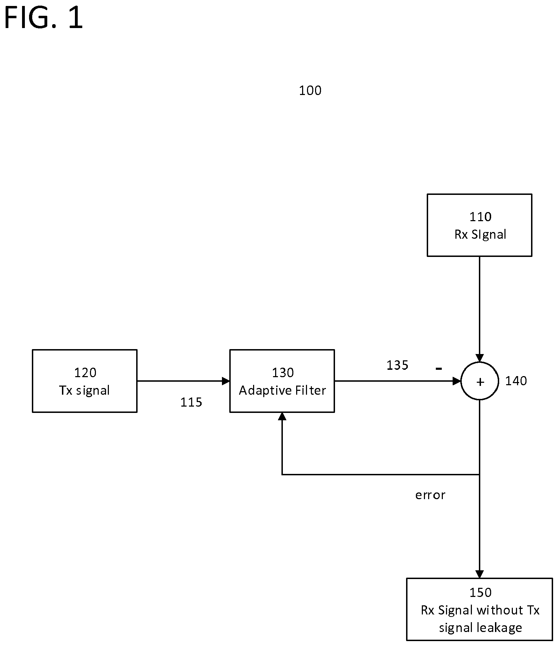

FIG. **1** shows an adaptive filter diagram **100** in an aspect of this disclosure. It is appreciated that adaptive filter diagram **100** is exemplary in nature and may therefore by simplified for purposes of this explanation. The ensuing explanation focuses on the application of the disclosed adaptive filter mechanism and methods to self-interference cancellation between transmit and receive equipment in a wireless device, but it is appreciated that the ensuing disclosure encompasses other adaptive filter applications, e.g. IM3 cancellation, digital pre-distortion, and 3G Radio Resource Control (RRC) equalization, as well. In these applications different to self-interference cancellation, the terminology for input and output signals would be changed according to use case.

In diagram **100,** the received signal (Rx signal) **110** includes the intended Rx signal (i.e. the signal as received at the device) plus interference produced by unknown signal leakage from the transmission equipment of the device (among other forms of interference).

However, the transmitted signal **120** cannot simply be subtracted from the Rx signal **110** in order to recover the intended Rx signal because this would not account for the effects of signal leakage from components of the Rx/Tx chain (e.g. mixers, amplifiers, converters, etc.). In order to account for the signal leakage, an adaptive filter **130** is implemented to produce a more accurate representation of the signal leakage interference in the adaptive filter signal, i.e. cancellation signal, **135**. This cancellation signal is then subtracted **140** from the Rx signal **110** in order to attempt to retrieve the intended Rx signal, i.e. the Rx signal without the Tx signal leakage, **150**. This resulting signal is fed back to the adaptive filter **130** as an error so the adaptive filter **130** may update the cancellation signal **135** in the next iteration.

In an aspect of this disclosure, adaptive filter **130** is implemented with an adaptive finite impulse response (FIR) filtering algorithm, which may be shown in the general form:

$$\boldsymbol{W}(n+1) = \boldsymbol{W}(n) + \mu(n) * \boldsymbol{F}(e(n), \boldsymbol{X}(n), \Phi(n)) \tag{1}$$

where $\boldsymbol{W}(n)$ is the parameter or coefficient vector at time (i.e. iteration) $n$, $\mu(n)$ is the step size at time $n$, and $\boldsymbol{F}(.)$ is a function dependent on the error signal $e(n)$, the input signal (i.e. Tx signal **120**) $\boldsymbol{X}(n)$, and a vector of states that stores other pertinent information, e.g. characteristics if the input and error signals, the coefficients at prior times, etc, $\Phi(n)$.

The focal point of the disclosure is the calculation of the step size (i.e. the weigh calculation applied in each iteration) of the adaptive filter. The step size ($\mu$) determines the magnitude of the change (i.e. "step") taken by the adaptive filter algorithm in iteratively determining a useful coefficient vector to be used in the next iteration (i.e. $\boldsymbol{W}(n + 1)$ in Equation (1)) of cancellation signal **135**.

Current adaptive filter implementations include LMS algorithms which have a constant step size (problem: slow settling), NLMS algorithms which normalize the step sizes with the power of the Tx signal (problem: lower accuracy), and RLS which uses complex matrix operations for step size calculations (problem: high operational complexity). By implementing the novel step size method of this disclosure, a highly accurate and quickly converging adaptive filter with low computational complexity is achieved.

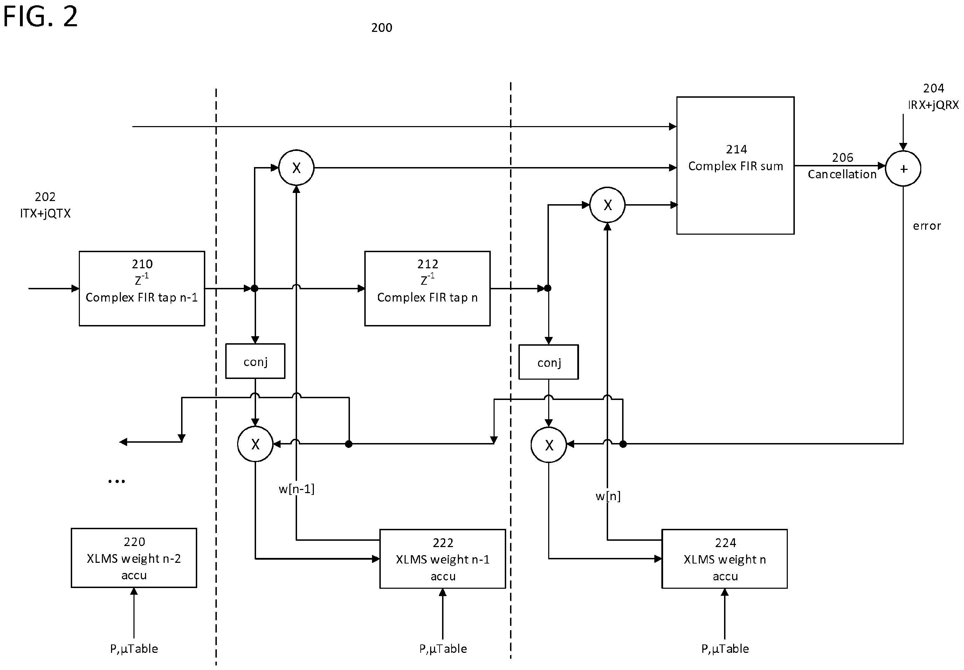

The following figure (FIG. 2) provides a more detailed configuration for adaptive filter **130** in this disclosure.

FIG. **2** shows a more detailed structure **200** for adaptive filter (i.e. for adaptive filter **130**). It is appreciated that configuration **200** is exemplary in nature and may therefore be simplified for purposes of this explanation.

The Tx and Rx signals are composed of both in-phase and quadrature components, shown as ITX+jQTX **202** and IRX+jQRX **204,** respectively. In terms of FIG. 1, ITX+jQTX **202** is representative of Tx signal **120** and IRX+jQRX **204** is representative of Rx signal **110**.

The complex FIR sum **214** sums all of the components of adaptive filter structure **200** in order to produce cancellation signal **206**. Complex filter taps **210-212** produce delays in adaptive filter structure **200** to determine the components to be summed by Complex FIR sum **214**.

The focal point of structure **200** as associated with this disclosure is in the weight (i.e. step size) determination performed for weight accumulators **220-224**. The dashed lines are meant to provide depiction of the different stages of the adaptive filter structure **200**.

A variable step size ($\mu$) is determined in each iteration of Equation 1. The lesser of two elements is chosen as the step size ($\mu$) for that particular iteration. The first element ($\mu$1) is inversely proportional to a time (t). In other words, $\mu$1 is a monotonically decreasing function as related to time, i.e. the number of iterations. The second element ($\mu$2) is determined from the power of the Tx signal. In other words, $\mu$2 may be determined in similar fashion to the NLMS step size.

The step size ($\mu$) chosen in each iteration may be demonstrated by the following equation:

$$\mu = \min(\mu 1, \mu 2) \tag{2}$$

where $\mu$1 is determined by the time of the iteration (i.e. at what point in time the iteration occurs) and $\mu$2 is a function of Tx power. The power calculation can be simplified by sum of the absolute values terms. By including a step size option ($\mu$1) dependent on time, the adaptive filter ensures high accuracy. By including a step size option ($\mu$2) dependent on the Tx power, the adaptive filter provides fast convergence and high stability.

A scaling of the time dependent step size ($\mu$1) may be implemented in order to account for interference and noise of the receive path. This scaling may be shown by the following equation:

$$\mu 1 = m_1 * f(t * t_1) \tag{3}$$

where function *f* has lower and upper boundaries for t = [0...inf] and typically monotonically decreasing characteristics inside constant boundaries (*e.g.* $f = \frac{0.4}{t*t_1+0.01} + 0.0005$ ), and $t_1$ and $m_1$ depend on the ratio of the power of the Rx signal to the expected Tx power within the Rx signal. More specifically, $t_1$ is a time-dependent component of the scaling and $m_1$ is a signal magnitude-dependent component. The scaling is chosen based on known or estimated Rx wanted level (or noise level or both) on the Rx input side. By implementing the scaling of $\mu 1$, as the noise increases, the scaling (i.e. via the values of $t_1$ and $m_1$) decreases in order to provide optimal results.

Furthermore, the step size determination for $\mu$ may be numerically limited to a minimum and maximum step size, where the minimum is determined by the required accuracy and tracking performance in the settled state of the system, and the maximum is determined to be a value slightly larger than the expected maximum step size which would be determined in a strictly NLMS implementation.

In another aspect of this disclosure, a cold/soft restart of the step size control may be employed, where the maximum step size of the control is dependent on changing signal conditions, e.g. the frequency allocation of the Tx signal. This, for example, may lead to a lower calculation for $\mu 1$.

In another aspect of this disclosure, in order to solve delay problems cause by long combination path to the cancellation point or in the error feedback portion presented by pipelining taps, a blind tap is introduced, for example, in place of Complex FIR tap n **212.**

In multi-kernel usage, where the same error signal is used for filter adaptation of two or more nonlinear terms of the Tx signal, the higher order/less dominating kernels are given a later start in order to improve convergence/settling. In case of discrete tables, only the first step size table entries (for $\mu 1$) in the corresponding kernels would be zero.

The $\mu 1$ step size may be realized by a 1/t decay, or more preferably, by a discrete step size table ($\mu$Table) and its scaling can be controlled by additional parameters, such as interference and/or noise or if boundary conditions are changing (e.g. signal levels or signal types).

Since the step size determination is a known decay function, multipliers in error feedback can use barrel shifters (e.g. two shift values, one for time iteration [0,...,t1] and one for time iterations greater than t1) in order to avoid big multiplier word lengths, thereby minimizing hardware requirements.

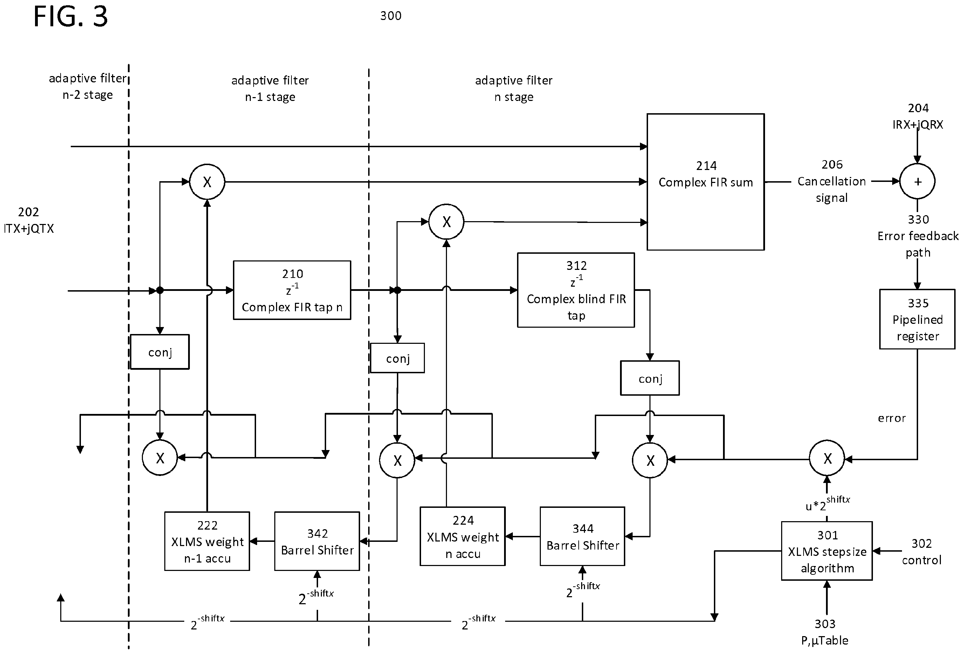

FIG. **3** shows a hardware (HW) implementation **300** in an aspect of this disclosure. It is appreciated that HW implementation **300** is exemplary in nature and may therefore be simplified for purposes of this disclosure. It is also realized that alternate forms of HW implementation which achieve analogous results by implementing the step size calculations of this disclosure are encompassed by the explanation herein.

HW implementation **300** is similar to the configuration disclosed in FIG. **2,** and therefore, the same reference numbers refer to similar components.

The aforementioned barrel shifters **342-344** are implemented in series with the XLMS weight accumulators **222-224** to avoid big multiplier word lengths and minimize hardware.

The Complex blind FIR tap **312** is employed in lieu of Complex FIR tap n **212** of FIG. **2** to, in addition to realizing the once cycle delay of tap **210,** to account for the compensating effect of the pipelined register **335,** which is introduced for synchronizing combination logic which may be included in the cancellation signal **206,** and therefore, find its way into the error feedback path **330.**

The XLMS step size algorithm is implemented into unit **301,** which selects the lesser of the step sizes, $\mu 1$ and $\mu 2$, determined from the $\mu$Table (i.e. time-dependent) and the Tx Power (P), respectively. Control **302** may introduce other inputs to the XLMS step size unit **301.** These inputs may include a cold/soft restart and/or a signal to interference ratio.

In another embodiment of this disclosure, a power detector may be implemented at the adaptive filter input (i.e. at **115** in FIG. 1), providing a Tx signal power check and switching the XLMS algorithm unit **301** to hold a coefficient state (i.e. stopping adaptation) if the Tx signal power is below a certain threshold. In other words, if the power of the Tx signal reaches low values or zero, i.e. there is no signal being transmitted, then there is no need to provide the adaption filtering. Or, the lower the Tx signal power, the less suppression and less adaptive filtering is needed in order to produce the intended Rx signal.

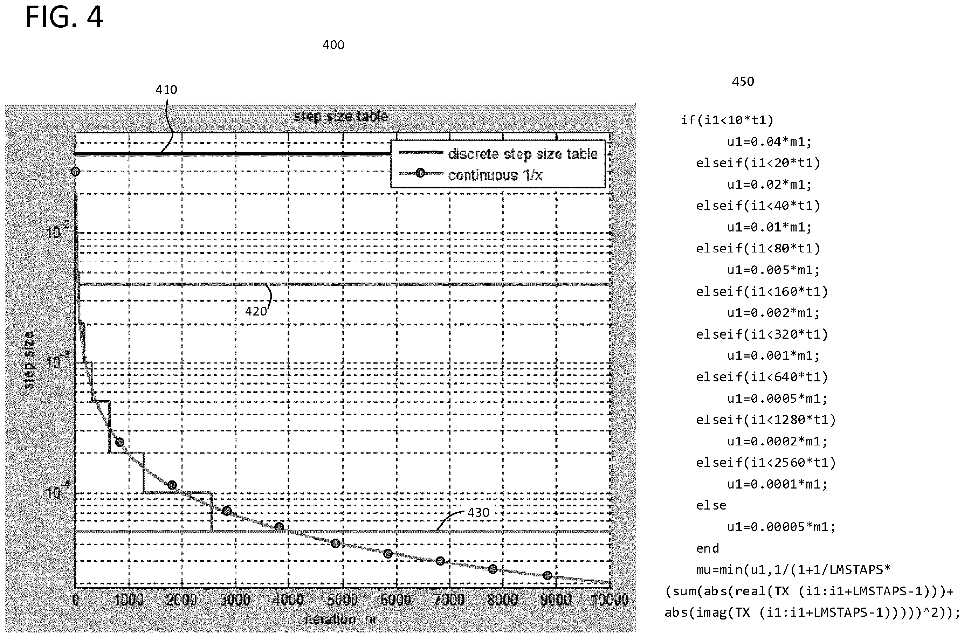

FIG. **4** shows an exemplary $\mu 1$ step size table (i.e. graph) **400** with corresponding exemplary code **450.** It is appreciated that graph **400** is exemplary in nature and may therefore be modified and still be encompassed within disclosure.

The discrete step size table line (i.e. $\mu 1$ step size table) is indicated by the step line depicted in graph **400.** This lines corresponds to the exemplary code **450.** It represents a typical cold start (adaptive filter weights starting from zero). Code **450** depicts the manner in which a predetermined step size table may be selected. It is appreciated that a similar step size table, with a similar descending step-like (i.e. monotonically decreasing) relationship between the step size and the number of iterations may be implemented.

The line marked by the circles represents 1/t behavior.

The region outlined by line **410** and line **420** is the region where the NLMS is potentially limiting, and the area below line **420** is the area where the 1/t behavior limits the step size in order achieve higher accuracy and better adaptation (i.e. better cancellation in case of SIC).

To achieve minimum tracking performance of this disclosure, the minimum step size of $\mu 1$ is limited to line **430**. In this manner, the smaller step sizes can be avoided in order to achieve faster convergence.

A soft restart table for $\mu 1$ would lower line **410** (i.e. the upper step size limit) to the region between line **420** and line **430**, assuming that the current adaptive filter weight state are not zero, but in fact closer to the optimum state.

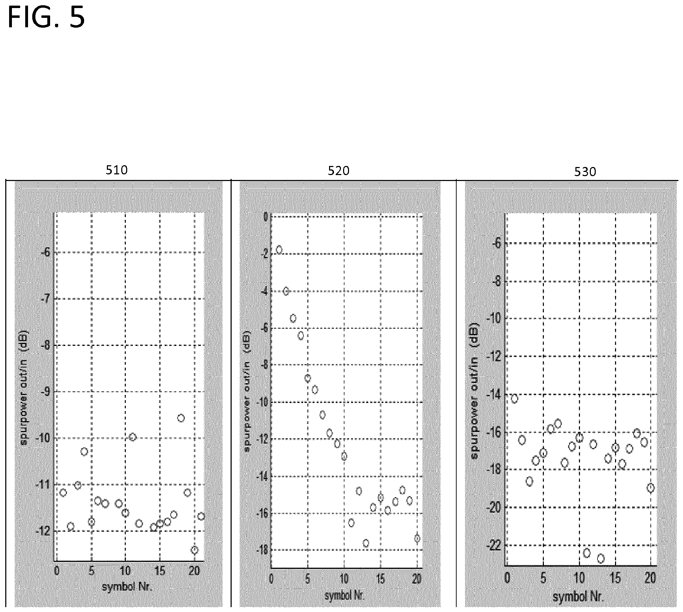

FIG. 5 shows a comparison of the settling behavior of an NLMS algorithm **510**, an LMS algorithm **520**, and the XLMS algorithm **530** of this disclosure.

The NLMS algorithm **510** shows good settling, but lacks the accuracy (i.e. the interference suppression) of the other signals are demonstrated by its spur power out/in ratio of about -11.5 dBs.

The LMS algorithm **520** (with a constant step size of 1.0E-4) shows good accuracy demonstrated by its spur power out/in ration of about -17 dBs, but it also shows slow settling as evident in the slow convergence to its final state.

On the other hand, the XLMS algorithm **530** shows both good settling and high accuracy when compared to **510** and **520**.

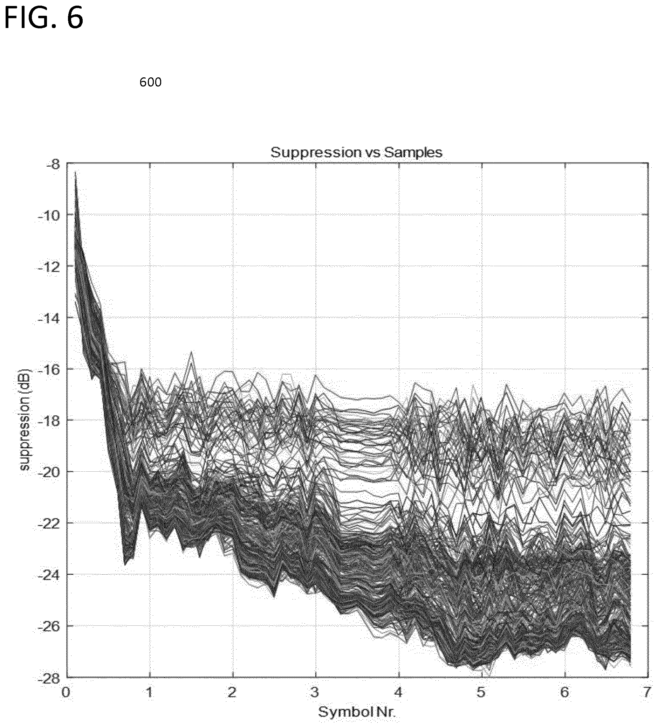

FIG. 6 is a graph **600** showing the settling performance of the XLMS algorithm of this disclosure for suppressing Tx spur in Rx signal for a low intended Rx signal using a 12-tap filter for adaption of multiple hundreds duplexer transfer functions, which results in the multiple hundred settling curves shown in graph **600**.

For the XLMS step size algorithm unit used to achieve the results in graph **600**, the scaling used in $\mu 1$ (as shown by Equation 3) was set with values of $t_1 = 2$ and $m_1 = 1$. A full allocation of LTE20 was used for the Tx signal and for the Rx signal LTE10. The suppression was calculated by the spur power out/spur power in, where the modulated spur power is equal to the noise power plus the intended Rx signal. One symbol number (along the x-axis) is equal to 0.5 ms (1 slot)/7symbols= 71 $\mu s$.

As is shown by graph **600**, none of the XLMS use cases fail to converge, and in the worst case scenario, the suppression ratio result is about -16.5 dB, which is a more than adequate result considering that the duplexer isolation has a strong frequency response with many notch type areas which are close to each other.

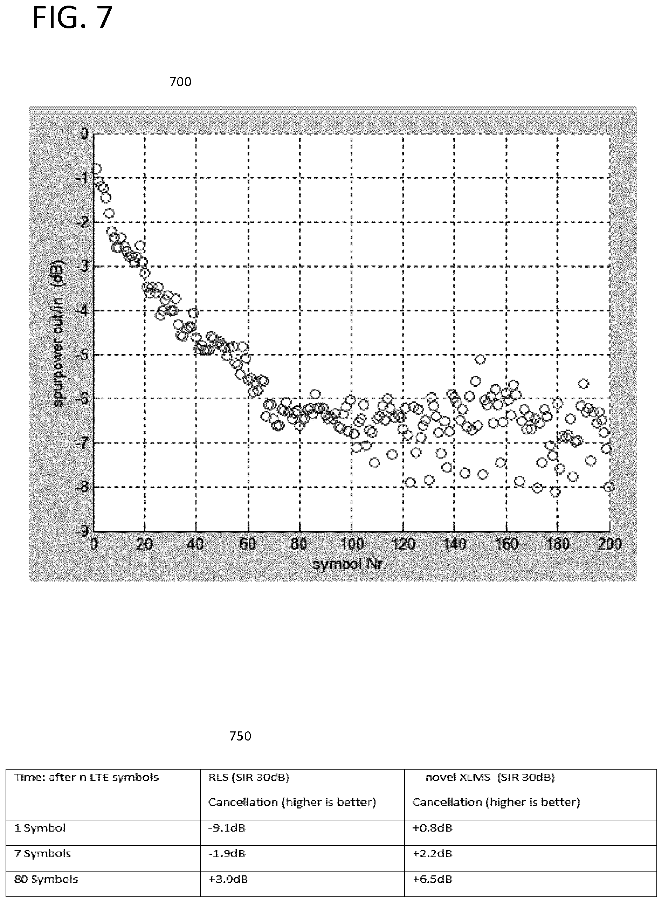

FIG. 7 shows a graph **700** depicting the settling performance of the XLMS algorithm of this disclosure for suppressing Tx spur in Rx signal for a high intended Rx signal. The Rx signal is 30 dB above Tx (LTE20) and the signal to interference ratio (SIR) is 30 dB, thereby implementing the adapted $\mu 1$ step size table.

A 12-tap filter was used and the scaling factors were set to $t_1 = 1$ and $m_1 = 0.1$. The measured data in graph **600** is the receiver signal.

The spur in/out of the XLMS algorithm of this disclosure after 7 symbols is about - 2.2 dBs, signifying a +2.2 dB interference cancellation. After 80 symbols, it is -6.5 dBs, signifying a 6.5 dB interference cancellation.

Chart **750** shows a comparison of the novel XLMS methods and mechanisms of this disclosure (in the second column) when compared to the highly computational complex RLS (in the first column) method in a high interference (30 dBs) scenario. Higher positive numbers indicate better results, with negative value indicating an increase in distortion, i.e. the cancellation circuit is counterproductive. As is clearly evident from chart **750**, the XLMS method and mechanism of this disclosure achieves better results that the RLS algorithm at a lower computational complexity.

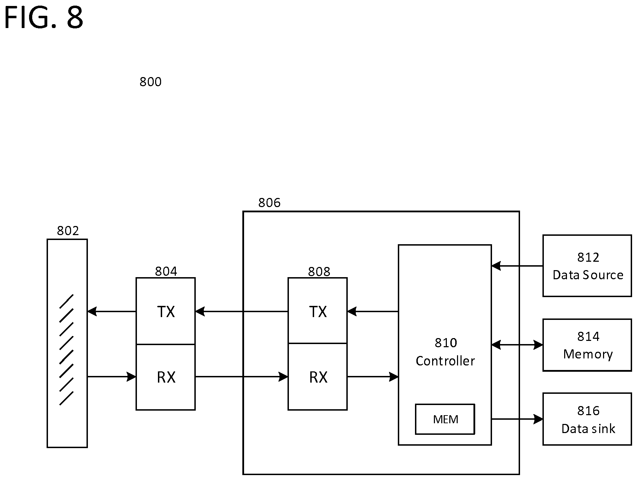

FIG. 8 shows an internal configuration of user equipment (UE) **800**, which may be configured to perform the adaptive filtering procedure of this disclosure. As shown in FIG. 8, UE **800** may include antenna system **802**, radio frequency (RF) transceiver **804**, baseband modem **806** (including physical layer processing circuit **808** and controller **810**), data source **812**, memory **814**, and data sink **816**. Although not explicitly shown in FIG. 8, UE **800** may include one or more additional hardware, software, and/or firmware components (such as processors/microprocessors, controllers/microcontrollers, other specialty or generic hardware/processors/circuits, etc.), peripheral device(s), memory, power supply, external device interface(s), subscriber identify module(s) (SIMs), user input/output devices (display(s), keypad(s), touchscreen(s), speaker(s), external button(s), camera(s), microphone(s), etc.), etc.

In an abridged operational overview, UE **800** may transmit and receive radio signals on one or more RANs. Baseband modem **806** may direct such communication functionality of UE **800** according to the communication protocols associated with each RAN, and may execute control over antenna system **802** and RF transceiver **804** in order to transmit and receive radio signals according to the formatting and scheduling parameters defined by each communication protocol.

UE **800** may transmit and receive radio signals with antenna system **802**, which may be a single antenna or an antenna array composed of multiple antennas and may additionally include analog antenna combination and/or beamforming circuitry. The receive path (RX) of RF transceiver **804** may receive analog radio frequency signals from antenna system **802** and perform analog and digital RF front-end processing on the analog radio frequency signals to produce digital baseband samples (e.g. In-Phase/Quadrature (IQ) samples) to provide to baseband modem **806**. RF transceiver **804** may accordingly include analog and digital reception circuitry including amplifiers (e.g. a Low Noise Amplifier (LNA), filters, RF demodulators (e.g. an RF IQ demodulator)), and analog-to-digital converters (ADCs) to convert the received radio frequency signals to digital baseband samples. In the transmit path (TX), RF transceiver **804** may receive digital baseband samples from baseband modem **806** and perform analog and digital RF front-end processing on the digital baseband samples to produce analog radio frequency signals to provide to antenna system **802** for wireless transmission. RF transceiver **804** may thus include analog and digital transmission circuitry including amplifiers (e.g. a Power Amplifier (PA), filters, RF modulators (e.g. an RF IQ modulator), and digital-to-analog converters (DACs) to mix the digital baseband samples received from baseband modem **806** to produce the analog radio frequency signals for wireless transmission by antenna system **802**. Baseband modem **806** may control the RF transmission and reception of RF transceiver **804**, including specifying transmit and receive radio frequencies for operation of RF transceiver **804**.

As shown in FIG. **8**, baseband modem **806** may include physical layer processing circuit **808**, which may perform physical layer (Layer 1) transmission and reception processing to prepare outgoing transmit data provided by controller **810** for transmission via RF transceiver **804** and prepare incoming received data provided by RF transceiver **804** for processing by controller **810**. Physical layer processing circuit **810** may accordingly perform one or more of adaptive filtering, error detection, forward error correction encoding/decoding, channel coding and interleaving, physical channel modulation/demodulation, physical channel mapping, radio measurement and search, frequency and time synchronization, antenna diversity processing, power control and weighting, rate matching, retransmission processing, etc. Physical layer processing circuit **808** may be structurally realized as hardware logic, e.g. as an integrated circuit or FPGA, as software logic, e.g. as program code defining arithmetic, control, and I/O instructions stored in a non-transitory computer-readable storage medium and executed on a processor, or as a combination of hardware and software logic. Although not explicitly shown in FIG. **8**, physical layer processing circuit **808** may include a control circuit such as a processor configured to control the various hardware and software processing components of physical layer processing circuit **808** in accordance with physical layer control logic defined by the communications protocol for the relevant radio access technologies (RATs). Furthermore, while physical layer processing circuit **808** is depicted as a single component in FIG. **8**, physical layer processing circuit **808** may be collectively composed separate sections of physical layer processing circuitry where each respective section is dedicated to the physical layer processing of a particular RAT.

Physical layer processing circuit **808** may include hardware and/or software to implement the adaptive filtering methods of this disclosure, e.g. as described in the other figures.

UE **800** may be configured to operate according to one or more RATs, which may be directed by controller **810**. Controller **810** may thus be responsible for controlling the radio communication components of UE **800** (antenna system **802**, RF transceiver **804**, and physical layer processing circuit **808**) in accordance with the communication protocols of each supported RAT, and accordingly may represent the Access Stratum (AS) and Non-Access Stratum (NAS) (also encompassing Layer 2 and Layer 3) of each supported RAT. Controller **810** may be structurally embodied as a protocol processor configured to execute protocol software (retrieved from controller memory **MEM** as shown in FIG. **4**) and subsequently control the radio communication components of UE **800** in order to transmit and receive communication signals in accordance with the corresponding protocol control logic defined in the protocol software.

Controller **810** may therefore be configured to manage the radio communication functionality of UE **800** in order to communicate with the various radio and core network components of a radio communication network, and accordingly may be configured according to the communication protocols for both the LTE network and the GSM/UMTS legacy network. Controller **810** may either be a unified controller that is collectively responsible for all supported RATs (e.g. LTE and GSM/UMTS) or may be composed of multiple separate controllers where each controller is a dedicated controller for a particular RAT, such as e.g. a dedicated LTE controller and a dedicated legacy controller (or alternatively a dedicated LTE controller, dedicated GSM controller, and a dedicated UMTS controller). Regardless, controller **810** may be responsible for directing radio communication activity of UE **800** according to the communication protocols of the LTE and legacy networks. As previously noted regarding physical layer processing circuit **808**, one or both of antenna system **802** and RF transceiver **804** may similarly be partitioned into multiple dedicated components that each respectively correspond to one or more of the supported RATs. Depending on the specifics of each such configuration and the number of supported RATs, controller **810** may be configured to control the radio communication operations of UE **800** in accordance with a master/slave RAT hierarchical or multi-SIM scheme.

UE **800** may further comprise data source **812**, memory **814**, and data sink **816**, where data source **812** may include sources of communication data above controller **810** (i.e. above the NAS/Layer 3) and data sink **816** may include destinations of communication data above controller **810** (i.e. above the NAS/Layer 3). Such may include, for example, an application processor of UE **800**, which may be configured to execute various applications and/or programs of UE **800** at an application layer of UE **800**, such as e.g. an Operating System (OS), a User Interface (UI) for supporting user interaction with UE **800**, and/or various user applications. The application processor may interface with baseband modem **806** (as data source **812**/data sink **816**) as an application layer to transmit and receive user data such as voice data, audio/video/image data, messaging data, application data, basic Internet/web access data, etc., over a the radio network connection(s) provided by baseband modem **806**. Data source **812** and data sink **816** may additionally represent various user input/output devices of UE **800**, such as display(s), keypad(s), touchscreen(s), speaker(s), external button(s), camera(s), microphone(s), etc., which may allow a user of UE **800** to control various communication functions of UE **800** associated with user data.

Memory **814** may embody a memory component of UE **800,** such as e.g. a hard drive or another such permanent memory device. Although not explicitly depicted in FIG. **8,** the various other components of UE **800** shown in FIG. **8** may additionally each include integrated permanent and non-permanent memory components, such as for storing software program code, buffering data, etc.

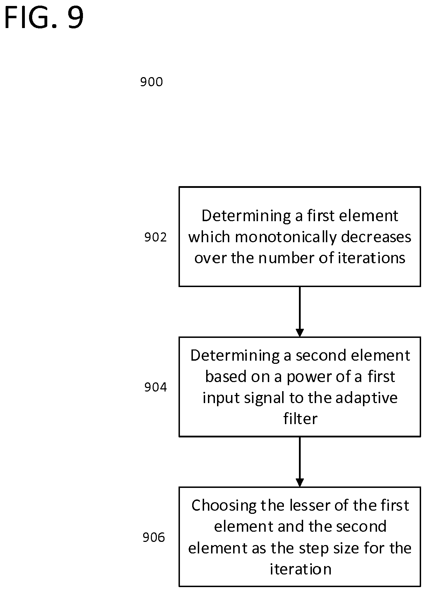

FIG. **9** shows a flowchart **900** detailing an adaptive filter method in an aspect of this disclosure. It is appreciated that flowchart **900** is exemplary in nature and may therefore be simplified for purposes of this explanation.

The adaptive filtering method described in flowchart **900** may be implemented by the physical processing layer circuit **808** of UE **800** in FIG. **8** in order to determine a step size (i.e. weight) for each iteration of an adaptive filtering process.

A first element is determined which monotonically decreases over the number of iterations **902.** For example, as the number of the iterations increases (i.e. as time increases), the first element will either decrease or stay the same (i.e. is monotonic in nature).

A second element is determined (i.e. calculated) from a power of the first input signal to the adaptive filter **904.** The first input signal may be, for example, the transmitted signal from the communication device which is interfering with the received signal. In this case, the adaptive filtering process disclosed herein is implemented in order to mimic the leakage of the transmitted signal into the received signal (in the transceiver and the physical processing layer circuit) in order to remove said leakage.

It is appreciated that the order of **902** and **904** may be switched or they may be performed simultaneously.

After determining the first and the second elements, the lesser of the two is chosen as the step size for that particular iteration of the adaptive filtering process **906.**

In Example 1, a circuitry for determining an adaptive filter step size for processing a received signal, the circuitry including an adaptive filter circuit configured to receive a first input signal and produce a variable cancellation signal, wherein a step size for each iteration of the variable cancellation signal is the lesser of a first element which monotonically decreases over the number of iterations; or a second element calculated from a power of the first input signal; and an evaluation circuit configured to subtract the variable cancellation signal from the received signal to generate a second input signal, wherein the adaptive filter circuit adjusts the variable cancellation signal based on the second input signal.

In Example 2, the subject matter of Example 1 may include wherein the first element is determined by a function which is inversely proportional to the number of iterations.

In Example 3, the subject matter of Example 1 may include wherein the first element is determined by a predetermined step size table.

In Example 4, the subject matter of Examples 1-3 may include wherein the second element is limited by a normalized least mean squares step size.

In Example 5, the subject matter of Examples 1-4 may include wherein the power of the first input signal is determined by the sum of the absolute value of its terms.

In Example 6, the subject matter of Examples 1-5 may include wherein a scalar is applied to the first element.

In Example 7, the subject matter of Example 6 may include wherein the scalar is dependent on an interference and/or a noise of the received signal.

In Example 8, the subject matter of Examples 6-7 may include wherein the scalar is represented by the formula:

$$\mu 1 = m_1 * f(t * t_1)$$

wherein function *f* has lower and upper boundaries and has substantially decreasing characteristics inside of the lower and upper boundaries, where $\mu_1$ is the first element, $m_1$ is a magnitude factor, $t_1$ is a time factor, and *t* is the time of the iteration.

In Example 9, the subject matter of Examples 1-8 may include wherein the step size is further limited by a minimum and maximum step size.

In Example 10, the subject matter of Example 9 may include wherein the minimum step size is determined by a predetermined required accuracy and tracking performance of the circuit in a settled state.

In Example 11, the subject matter of Examples 9-10 may include wherein the maximum step size is determined by an expected maximum of the second element.

In Example 12, the subject matter of Example 11 may include wherein a maximum of the first element is larger than the expected maximum of the second element.

In Example 13, the subject matter of Examples 1-12 may include the adaptive filter comprising barrel shifters, wherein each barrel shifter comprises a shift value.

In Example 14, the subject matter of Example 13 may include the barrel shifters configured to provide multipliers in the second input signal feedback with shift values.

In Example 15, the subject matter of Examples 13-14 may include wherein a first barrel shifter comprises a shift value for time iterations between 0 and tb, inclusive of tb.

In Example 16, the subject matter of Examples 13-15 may include wherein a second barrel shifter comprises a second shift value for time iterations greater than tb.

In Example 17, the subject matter of Examples 1-16 may include the adaptive filter comprising a complex FIR unit configured to receive as input a plurality of outputs from registers from within the adaptive filter and output the variable cancellation signal.

In Example 18, the subject matter of Examples 1-17 may include the adaptive filter comprising one or more complex FIR taps configured to implement a one cycle delay.

In Example 19, the subject matter of Examples 1-18 may include the adaptive filter comprising at least one complex FIR blind tap configured to implement a compensating effect of a pipelined register in the circuitry.

In Example 20, the subject matter of Examples 1-19 may include a power detector configured to detect the power of the first input signal.

In Example 21, the subject matter of Example 20 may include wherein the power detector is further configured to stop the adaptive filter from producing the variable cancellation signal if the first input signal falls below a certain threshold.

In Example 22, the subject matter of Examples 1-21 may include wherein the circuitry is in a signal processing component of a communication device.

In Example 23, the subject matter of Examples 1-22 may include an input circuit configured to provide the first input signal to the adaptive filter unit.

In Example 24, the subject matter of Examples 1-23 may include wherein the first input signal is a transmission signal of a communication device.

In Example 25, the subject matter of Examples 1-24 may include wherein the circuitry is implemented as a self-interference cancellation (SIC) circuit in a communication device with duplex mode capabilities.

In Example 26, the subject matter of Examples 1-25 may include wherein the circuity performs a time domain equalization in a communication device.

In Example 27, a communication device including a transceiver configured to receive a signal from a network; and a baseband processing component, including an adaptive filter circuit, configured to: receive a first input signal and produce a variable cancellation signal, wherein a step size for each iteration of the variable cancellation signal is the lesser of: a first element which monotonically decreases over the number of iterations; or a second element calculated from a power of the first input signal; and subtract the variable cancellation signal from the signal received from the network to generate a second input signal; and control the adaptive filter circuit to adjust the variable cancellation signal based on the second input signal.

In Example 28, the subject matter of Example 27 may include wherein the first element is determined by a function which is inversely proportional to the number of the iteration.

In Example 29, the subject matter of Example 27 may include wherein the first element is determined by a predetermined step size table.

In Example 30, the subject matter of Examples 27-29 may include wherein the second element is limited by a normalized least mean squares step size.

In Example 31, the subject matter of Examples 27-30 may include wherein the power of the first input signal is determined by the sum of the absolute value of its terms.

In Example 32, the subject matter of Examples 27-31 may include wherein a scalar is applied to the first element.

In Example 33, the subject matter of Example 32 may include wherein the scalar is dependent on an interference and/or a noise of the signal received from the network.

In Example 34, the subject matter of Examples 32-33 may include wherein the scalar is represented by the formula:

$$\mu1 = m_1 * f(t * t_1)$$

wherein function $f$ has lower and upper boundaries and has substantially decreasing characteristics inside of the lower and upper boundaries, where $\mu_1$ is the first element, $m_1$ is a magnitude factor, $t_1$ is a time factor, and t is the time of the iteration.

In Example 35, the subject matter of Examples 27-34 may include wherein the step size is further limited by a minimum and maximum step size.

In Example 36, the subject matter of Example 35 may include wherein the minimum step size is determined by a predetermined required accuracy and tracking performance of the circuit in a settled state.

In Example 37, the subject matter of Examples 35-36 may include wherein the maximum step size is determined by an expected maximum of the second element.

In Example 38, the subject matter of Example 37 may include wherein a maximum of the first element is larger than the expected maximum of the second element.

In Example 39, the subject matter of Examples 27-38 may include the adaptive filter comprising barrel shifters, wherein each barrel shifter comprises a shift value.

In Example 40, the subject matter of Example 39 may include the barrel shifters configured to provide multipliers in the second input signal feedback with shift values.

In Example 41, the subject matter of Examples 39-40 may include wherein a first barrel shifter comprises a shift value for time iterations between 0 and tb, inclusive of tb.

In Example 42, the subject matter of Examples 39-41 may include wherein a second barrel shifter comprises a second shift value for time iterations greater than tb.

In Example 43, the subject matter of Examples 27-42 may include the adaptive filter comprising a complex FIR unit configured to receive as input a plurality of outputs from registers from within the adaptive filter and output the variable cancellation signal.

In Example 44, the subject matter of Examples 27-43 may include the adaptive filter comprising one or more complex FIR taps configured to implement a one cycle delay.

In Example 45, the subject matter of Examples 27-44 may include the adaptive filter comprising at least one complex FIR blind tap configured to implement a compensating effect of a pipelined register in the circuitry.

In Example 46, the subject matter of Examples 27-45 may include further comprising a power detector configured to detect the power of the first input signal.

In Example 47, the subject matter of Example 46 may include wherein the power detector is further configured to stop the adaptive filter from producing the variable cancellation signal if the first input signal falls below a certain threshold.

In Example 48, the subject matter of Examples 27-47 may include wherein the circuitry is in a signal processing component of a communication device.

In Example 49, the subject matter of Examples 27-48 may include an input circuit configured to provide the first input signal to the adaptive filter unit.

In Example 50, the subject matter of Examples 27-49 may include wherein the first input signal is a transmission signal of a communication device.

In Example 51, the subject matter of Examples 27-50 may include wherein the circuitry is implemented as a self-interference cancellation (SIC) circuit in a communication device with duplex mode capabilities.

In Example 52, the subject matter of Examples 27-51 may include wherein the baseband processing component performs a time domain equalization in a communication device.

In Example 53, the subject matter of Example 52 may include wherein a CDMA component of the baseband processing component performs the time domain equalization.

In Example 54, a method for determining a step size for each iteration of a variable cancellation signal of produced by an adaptive filter in a processing circuitry of a communication device, the method including: determining a first element which monotonically decreases over the number of iterations; determining a second element based on a power of a first input signal to the adaptive filter; and choosing the lesser of the first element and the second element as the step size for the iteration.

In Example 55, the subject matter of Example 54 may include determining the first element by a function which is inversely proportional to the number of the iteration.

In Example 56, the subject matter of Example 54 may include determining the first element with a predetermined step size table.

In Example 57, the subject matter of Examples 54-56 may include limiting the second element by a normalized least mean squares step size.

In Example 58, the subject matter of Examples 54-57 may include determining the power of the first input signal by the sum of the absolute value of its terms.

In Example 59, the subject matter of Examples 54-58 may include applying a scalar to the first element.

In Example 60, the subject matter of Example 59 may include wherein the scalar is dependent on an interference and/or a noise of a signal received at the communication device.

In Example 61, the subject matter of Examples 59-60 may include wherein the scalar is represented by the formula:

$$\mu1 = m_1 * f(t * t_1)$$

wherein function $f$ has lower and upper boundaries and has substantially decreasing characteristics inside of the lower and upper boundaries, where $\mu_1$ is the first element, $m_1$ is a magnitude factor, $t_1$ is a time factor, and $t$ is the time of the iteration.

In Example 62, the subject matter of Examples 54-61 may include limiting the step size by a minimum and maximum step size.

In Example 63, the subject matter of Example 62 may include determining the minimum step size by a predetermined required accuracy and tracking performance of the circuit in a settled state.

In Example 64, the subject matter of Examples 62-63 may include determining the maximum step size by an expected maximum of the second element.

In Example 65, the subject matter of Example 64 may include wherein a maximum step size of the first element is larger than the expected maximum of the second element.

In Example 66, the subject matter of Examples 64-65 may include providing barrel shifters to provide multipliers of the second input signal feedback of the adaptive filter with shift values.

In Example 67, the subject matter of Example 66 may include wherein a first barrel shifter comprises a shift value for time iterations between 0 and tb, inclusive of tb.

In Example 68, the subject matter of Examples 66-67 may include wherein a second barrel shifter comprises a second shift value for time iterations greater than tb.

In Example 69, the subject matter of Examples 54-68 may include providing a power detector configured to detect the power of the first input signal.

In Example 70, the subject matter of Example 69 may include configuring the power detector to stop the adaptive filter from producing the variable cancellation signal if the first input signal falls below a certain threshold.

In Example 71, a computer readable medium with program instructions when executed cause a processor of a device to implement a method or realize an apparatus as claimed in any preceding Example.

While the above descriptions and connected figures may depict electronic device components as separate elements, skilled persons will appreciate the various possibilities to combine or integrate discrete elements into a single element. Such may include combining two or more circuits for form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

While the invention has been particularly shown and described with reference to specific embodiments, it should be understood by those skilled in the art that various changes in form and detail may be made therein without departing from the scope of the invention as defined by the appended claims. The scope of the invention is thus indicated by the appended claims and all changes which come within the meaning and range of equivalency of the claims are therefore intended to be embraced.

**Claims**

1. A circuitry (100) for determining an adaptive filter step size for processing a received signal (110), the circuitry comprising:

    an adaptive filter circuit (130) configured to receive a first input signal (120) and produce a variable cancellation signal (135), wherein a step size for each iteration of the variable cancellation signal is the lesser of:

    a first step size option which monotonically decreases over the number of iterations (400); or
    a second step size option calculated from a power of the first input signal; and an evaluation circuit (140) configured to subtract the variable cancellation signal (135) from the received signal (110) to generate a second input signal (150), wherein the adaptive filter circuit (130) adjusts the variable cancellation signal (135) based on the second input signal (150).

2. The circuitry of claim 1, wherein the first step size option is determined by a function which is inversely proportional to the number of iterations.

3. The circuitry of claim 1, wherein the first step size option is determined by a predetermined step size table.

4. The circuitry of any one of claims 1-3, wherein the second step size option is limited by a normalized least mean squares step size.

5. The circuitry of any one of claims 1-4, wherein a scalar is applied to the first step size option.

6. The circuitry of claim 5, wherein the scalar is dependent on an interference and/or a noise of the received signal.

7. The circuitry of any one of claims 5-6, wherein the scalar is represented by the formula:

$$\mu1 = m_1 * f(t * t_1)$$

wherein function $f$ has lower and upper boundaries and has substantially decreasing characteristics inside of the lower and upper boundaries, where $\mu_1$ is the first step size option, $m_1$ is a magnitude factor, $t_1$ is a time factor, and $t$ is the time of the iteration.

8. The circuitry of any one of claims 1-7, wherein the step size is further limited by a minimum and maximum step size.

9. The circuitry of any one of claims 1-8, the adaptive filter comprising barrel shifters, wherein each barrel shifter comprises a shift value.

10. The circuitry of any one of claims 1-9, wherein the circuitry is in a signal processing component of a communication device.

11. A method for determining a step size for each iteration of a variable cancellation signal (135) produced by an adaptive filter (130) in a processing circuitry of a device, the method comprising:

determining a first step size option which monotonically decreases over the number of iterations;
determining a second step size option based on a power of a first input signal (120) to the adaptive filter (130); and
choosing the lesser of the first step size option and the second step size option as the step size for the iteration.

12. The method of claim 11, further comprising determining the first step size option by a function which is inversely proportional to the number of iterations.

13. The method of claim 11, further comprising determining the first step size option with a predetermined step size table.

14. The method of any one of claims 11-13, further comprising applying a scalar to the first step size option.

15. Machine-readable storage including machine-readable instructions, when executed, to implement a method or realize a circuitry as claimed in any preceding claim.


**Patentansprüche**

1. Schaltung (100) zum Bestimmen der Schrittgröße eines adaptiven Filters für die Verarbeitung eines Empfangssignals (110), wobei die Schaltung umfasst:
eine adaptive Filterschaltung (130), die dafür ausgelegt ist, ein erstes Eingangssignal (120) zu empfangen und ein variables Kompensationssignal (135) zu erzeugen, wobei eine Schrittgröße für jede Iteration des variablen Kompensationssignals das kleinere der folgenden ist:

eine erste Schrittgrößenoption, die über die Anzahl der Iterationen hinweg monoton abnimmt (400); oder
eine zweite Schrittgrößenoption, die aus einer Stärke des ersten Eingangssignals errechnet wird; und
eine Auswertungsschaltung (140), die dafür ausgelegt ist, das variable Kompensationssignal (135) vom Empfangssignal (110) abzuziehen, um ein zweites Eingangssignal (150) zu erzeugen, wobei die adaptive Filterschaltung (130) das variable Kompensationssignal (135) basierend auf dem zweiten Eingangssignal (150) anpasst.

2. Schaltung nach Anspruch 1, wobei die erste Schrittgrößenoption durch eine Funktion bestimmt wird, die umgekehrt proportional zur Anzahl der Iterationen ist.

3. Schaltung nach Anspruch 1, wobei die erste Schrittgrößenoption durch eine Tabelle mit vorbestimmten Schrittgrößen bestimmt wird.

4. Schaltung nach einem der Ansprüche 1-3, wobei die zweite Schrittgrößenoption durch eine "Normalized Least Mean Squares" (normalisierte kleinste Quadrate)-Schrittgröße begrenzt ist.

5. Schaltung nach einem der Ansprüche 1-4, wobei ein Skalar auf die erste Schrittgrößenoption angewendet wird.

6. Schaltung nach Anspruch 5, wobei der Skalar von einer Störung und/oder einem Rauschen im Empfangssignal abhängt.

7. Schaltung nach einem der Ansprüche 5-6, wobei der Skalar durch folgende Formel dargestellt wird:

$$\mu 1 = m_1 * f(t * t_1)$$

wobei die Funktion $f$ eine Unter- und eine Obergrenze aufweist und im Wesentlichen abnehmende Merkmale innerhalb der Unter- und Obergrenze zeigt, wobei $\mu_1$ die erste Schrittgrößenoption ist, $m_1$ ein Größenfaktor ist, $t_1$ ein Zeitfaktor ist und $t$ die Zeit der Iteration ist.

8. Schaltung nach einem der Ansprüche 1-7, wobei die Schrittgröße ferner durch eine minimale und eine maximale Schrittgröße begrenzt ist.

9. Schaltung nach einem der Ansprüche 1-8, wobei das adaptive Filter Bitstellenverschieber umfasst, wobei jeder Bitstellenverschieber einen Verschiebewert umfasst.

10. Schaltung nach einem der Ansprüche 1-9, wobei die Schaltung in einer Signalverarbeitungskomponente einer Kommunikationsvorrichtung enthalten ist.

11. Verfahren zum Bestimmen einer Schrittgröße für jede Iteration eines variablen Kompensationssignals (135), das von einem adaptiven Filter (130) in einer Verarbeitungsschaltung einer Vorrichtung erzeugt wird, wobei das Verfahren umfasst:

Bestimmen einer ersten Schrittgrößenoption, die über die Anzahl der Iterationen hinweg monoton abnimmt;
Bestimmen einer zweiten Schrittgrößenoption basierend auf der Stärke eines ersten Eingangssignals (120) in das adaptive Filter (130); und
Wählen des kleineren von der ersten Schrittgrößenoption und der zweiten Schrittgrößenoption als Schrittgröße für die Iteration.

12. Verfahren nach Anspruch 11, ferner umfassend das Bestimmen der ersten Schrittgrößenoption durch eine Funktion, die umgekehrt proportional zur Anzahl der Iterationen ist.

13. Verfahren nach Anspruch 11, ferner umfassend das Bestimmen der ersten Schrittgrößenoption mittels einer Tabelle mit vorbestimmten Schrittgrößen.

14. Verfahren nach einem der Ansprüche 11-13, ferner umfassend das Anwenden eines Skalars auf die erste Schrittgrößenoption.

15. Maschinenlesbarer Speicher, der maschinenlesbare Anweisungen enthält, die, wenn sie ausgeführt werden, ein Verfahren oder eine Schaltung nach einem der vorstehenden Ansprüche implementieren.

**Revendications**

1. Circuits (100) de détermination d'une taille de pas de filtre adaptatif pour traiter un signal reçu (110), les circuits comprenant :

un circuit de filtre adaptatif (130) configuré pour recevoir un premier signal d'entrée (120) et produire un signal de suppression variable (135), dans lequel une taille de pas de chaque itération du signal de suppression variable est la plus petite :

d'une première option de taille de pas qui décroît de façon monotone durant le nombre d'itérations (400) ; ou d'une seconde option de taille de pas calculée à partir d'une puissance du premier signal d'entrée ; et

un circuit d'évaluation (140) configuré pour soustraire le signal de suppression variable (135) du signal reçu (110) pour générer un second signal d'entrée (150), le circuit de filtre adaptatif (130) ajustant le signal de suppression variable (135) en fonction du second signal d'entrée (150).

2. Circuits selon la revendication 1, dans lesquels la première option de taille de pas est déterminée par une fonction inversement proportionnelle au nombre d'itérations.

3. Circuits selon la revendication 1, dans lesquels la première option de taille de pas est déterminée par une table de tailles de pas prédéterminée.

4. Circuits selon l'une quelconque des revendications 1 à 3, dans lesquels la seconde option de taille de pas est limitée par une taille de pas par les moindres carrés normalisée.

5. Circuits selon l'une quelconque des revendications 1 à 4, dans lesquels un scalaire est appliqué à la première option de taille de pas.

6. Circuits selon la revendication 5, dans lesquels le scalaire dépend d'un brouillage et/ou d'un bruit du signal reçu.

7. Circuits selon l'une quelconque des revendications 5 et 6, dans lesquels le scalaire est représenté par la formule :

$$\mu1 = m_1 * f(t * t_1)$$

dans lesquels la fonction $f$ a des limites inférieure et supérieure et présente des caractéristiques sensiblement décroissantes en deçà des limites inférieure et supérieure, où $\mu_1$ est la première option de taille de pas, $m_1$ est un facteur de grandeur, $t_1$ est un facteur de temps, et $t$ est le temps de l'itération.

8. Circuits selon l'une quelconque des revendications 1 à 7, dans lesquels la taille de pas est limitée en outre par une taille de pas minimale et maximale.

9. Circuits selon l'une quelconque des revendications 1 à 8, le filtre adaptatif comprenant des circuits de décalage circulaire, chaque circuit de décalage circulaire comprenant une valeur de décalage.

10. Circuits selon l'une quelconque des revendications 1 à 9, les circuits se trouvant dans un composant de traitement de signaux d'un dispositif de communications.

11. Procédé de détermination d'une taille de pas de chaque itération d'un signal de suppression variable (135) produit par un filtre adaptatif (130) dans des circuits de traitement d'un dispositif, le procédé comprenant :

la détermination d'une première option de taille de pas qui décroît de façon monotone durant le nombre d'itérations ;
la détermination d'une seconde option de taille de pas en fonction d'une puissance d'un premier signal d'entrée (120) du filtre adaptatif (130) ; et
le choix de la plus petite de la première option de taille de pas et de la seconde option de taille de pas comme taille de pas de l'itération.

12. Procédé selon la revendication 11, comprenant en outre de la détermination de la première option de taille de pas par une fonction inversement proportionnelle au nombre d'itérations.

**13.** Procédé selon la revendication 11, comprenant en outre la détermination de la première option de taille de pas avec une table de tailles de pas prédéterminée.

**14.** Procédé selon l'une quelconque des revendications 11 à 13, comprenant en outre l'application d'un scalaire à la première option de taille de pas.

**15.** Mémoire lisible par machine comportant des instructions lisibles par machines qui, à leur exécution, mettent en oeuvre un procédé ou réalisent des circuits selon l'une quelconque des revendications précédentes.

# FIG. 1

100

```
                                          ┌─────────────┐
                                          │    110      │
                                          │  Rx SIgnal  │
                                          └─────────────┘
                                                 │
                                                 │
                                                 ▼
┌─────────────┐        ┌─────────────────┐  135    ─   ╭───╮
│    120      │        │      130        │──────────────│ + │  140
│  Tx signal  │───────▶│ Adaptive Filter │              ╰───╯
└─────────────┘  115   └─────────────────┘                │
                              ▲                            │
                              │                            │
                              └────────────────────────────┤
                                                           │
                                                   error   │
                                                           ▼
                                          ┌──────────────────────┐
                                          │         150          │
                                          │  Rx Signal without Tx │
                                          │     signal leakage    │
                                          └──────────────────────┘
```

FIG. 2

200

EP 3 301 810 B1

18

# FIG. 3

300

EP 3 301 810 B1

19

# FIG. 4

400

450

```
if(i1<10*t1)
    u1=0.04*m1;
  elseif(i1<20*t1)
    u1=0.02*m1;
  elseif(i1<40*t1)
    u1=0.01*m1;
  elseif(i1<80*t1)
    u1=0.005*m1;
  elseif(i1<160*t1)
    u1=0.002*m1;
  elseif(i1<320*t1)
    u1=0.001*m1;
  elseif(i1<640*t1)
    u1=0.0005*m1;
  elseif(i1<1280*t1)
    u1=0.0002*m1;
  elseif(i1<2560*t1)
    u1=0.0001*m1;
  else
    u1=0.00005*m1;
  end
  mu=min(u1,1/(1+1/LMSTAPS*
(sum(abs(real(TX (i1:i1+LMSTAPS-1)))+
abs(imag(TX (i1:i1+LMSTAPS-1)))))^2));
```

# FIG. 5

# FIG. 6

600

Suppression vs Samples

# FIG. 7

700

750

| Time: after n LTE symbols | RLS (SIR 30dB) Cancellation (higher is better) | novel XLMS (SIR 30dB) Cancellation (higher is better) |
|---|---|---|
| 1 Symbol | -9.1dB | +0.8dB |
| 7 Symbols | -1.9dB | +2.2dB |
| 80 Symbols | +3.0dB | +6.5dB |

# FIG. 8

800

806

802

804

808

810
Controller

812
Data Source

814
Memory

816
Data sink

TX

TX

RX

RX

MEM

# FIG. 9

900

```
902  ┌─────────────────────────────┐
     │   Determining a first element│
     │ which monotonically decreases│
     │    over the number of iterations│
     └─────────────────────────────┘
                    │
                    ▼
904  ┌─────────────────────────────┐
     │ Determining a second element │
     │   based on a power of a first│
     │   input signal to the adaptive│
     │            filter            │
     └─────────────────────────────┘
                    │
                    ▼
906  ┌─────────────────────────────┐
     │ Choosing the lesser of the first│
     │       element and the second │
     │   element as the step size for the│
     │            iteration         │
     └─────────────────────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130173678 A
- US 20040047464 A
- EP 0400850 A
- US 9407298 B
- US 20140247757 A